# EUROPÄISCHE PATENTSCHRIFT

(11) **EP 1 856 730 B1**
(45) Veröffentlichungstag und Bekanntmachung des Hinweises auf die Patenterteilung: **29.12.2010**
(21) Anmeldenummer: 06700022.4
(22) Anmeldetag: 09.01.2006
(51) Int. Cl.: H01L 21/68, H01L 21/00

(54) **VERFAHREN ZUR POSITIONIERUNG EINES WAFERS**
METHOD FOR POSITIONING A WAFER
PROCEDE DE POSITIONNEMENT D'UNE PLAQUETTE

(30) Priorität: 22.02.2005 CH 3092005
(43) Veröffentlichungstag der Anmeldung: 21.11.2007
(73) Patentinhaber: OC Oerlikon Balzers AG, 9496 Balzers (LI)
(72) Erfinder: SCHOLTE VAN MAST, Bart, CH-9478 Azmoos (CH); CHRIST, Holger, CH-9478 Azmoos (CH); SCHMUCKI, Ruedi, CH-9470 Buchs (CH)
(74) Vertreter: Wegmann, Urs
(86) Internationale Anmeldenummer: PCT/CH2006/000015
(87) Internationale Veröffentlichungsnummer: WO 2006/089435

(56) Entgegenhaltungen:
- US-A- 5 264 918
- US-A1- 2003 231 950
- US-A1- 2004 253 091
- US-B1- 6 342 705
- US-B1- 6 760 976

## Beschreibung

Die Erfindung bezieht sich auf ein Verfahren zur Positionierung eines Wafers mit einer Bezugsmarke in einer Vakuumprozessanlage gemäss Anspruch 1.

Bei modernen Vakuumprozessanlagen werden kreisrunde, flache Substrate bzw. Werkstücke, die auch als Wafer bezeichnet werden, in solchen vollautomatisierten Vakuumprozesssystemen oberflächenbehandelt, wie beispielsweise beschichtet, geätzt, gereinigt, thermisch behandelt etc. Um derartige Prozesse zu automatisieren und um mehrstufige Prozesse in verschiedenen Anlagenbereichen durchführen zu können, werden hierbei automatisierte Transportsysteme, eine Art Handling-Roboter, eingesetzt. Insbesondere die Behandlung von Halbleiterwafer erfordert bei derartigen Prozessen eine sehr hohe Qualität der Behandlung, wie insbesondere hohe Reinheit, hohe Präzision und sorgfältiges Behandeln der Substrate. Wegen den erwähnt hohen Anforderungen weisen derartige Anlagen bevorzugt eine Schleusenkammer auf, wo die Wafer von atmosphärischer Umgebung in einen Vakuumraum verbracht werden und danach in eine Prozessstation oder in der Regel nacheinander in mehrere Prozessstationen, um die geforderte Oberflächenbearbeitung vornehmen zu können. Die Wafer werden hierbei mit Hilfe einer Transporteinrichtung in einer horizontalen Transportebene von der Schleusenkammer in die Prozesskammer gebracht, wobei nach Ablegen des Wafers in der Prozesskammer diese in der Regel abgeschlossen wird, um dort den Prozess unter den geforderten Vakuum- und Prozessbedingungen durchführen zu können. Auf die selbe Art und Weise wird, wenn mehrere Prozessschritte benötigt werden, der Wafer wieder aus der einen Prozesskammer heraustransportiert und für den nächsten Prozessschritt in eine andere Prozesskammer transportiert. Besonders bevorzugte Anlagentypen sind hierbei sogenannte Clustersysteme. Bei derartigen Systemen wird die Schleusenkammer und die Prozesskammer bzw. mehrere Kammern um die im wesentlichen zentrale Transportkammer peripher angeordnet. Bei mehr als einer Schleusenkammer und insbesondere bei mehreren Prozesskammern werden diese Kammern in einer Art sternförmigen Anordnung um die zentral liegende Transportkammer angeordnet. Die Transporteinrichtung befindet sich dann in dieser zentral liegenden Transportkammer und hat Zugriff einerseits auf die mindestens eine Schleusenkammer und andererseits auf die Prozesskammern. Zwischen der Transportkammer und den übrigen Kammern wird üblicherweise und bevorzugt ein sogenanntes Schleusenventil angeordnet, um die Kammern gegeneinander beim Schleusenvorgang bzw. beim Prozessschritt gegeneinander abschotten zu können. Beim Transportvorgang eines Wafers greift dann die Transporteinrichtung entsprechend durch die offenen Schleusentore hindurch, um den Wafer am gewünschten Ort abzulegen.

Die Transporteinrichtung bewegt den Wafer translatorisch in einer Ebene und somit in zwei Bewegungsrichtungen. Bei den vorerwähnten bevorzugten Clustersystemen mit in der zentralen Transportkammer angeordneten Transporteinrichtung ist diese üblicherweise als Vorrichtung ausgebildet welche um ein Rotationszentrum dreht und damit die eine rotierende Bewegungsrichtung bildet und welche eine weitere zweite translatorische Bewegung radial zu diesem Rotationszentrum von diesem Rotationszentrum weg und hin ausführen kann. Auf dieser Transporteinrichtung, beispielsweise einem in horizontaler Ebene drehbaren, in der Länge verstellbaren Armmechanismus, wird dann der zu transportierende Wafer im Endbereich dieses Armes abgelegt. Eine derartige Anordnung kann dann ohne weiteres auch über grössere Wegdistanzen, beispielsweise in Grössenordnungen von 1 m oder mehr, einen Wafer von einer Schleusenkammer in die Transportkammer und von dort wiederum in die Prozesskammern hinein- und hinaustransportieren und durch die entsprechenden geöffneten Schleusentüren hindurch greifen. Der Wafer wird zu Beginn des Transportzyklus an Atmosphäre auf der Transportvorrichtung so präzise wie möglich und immer in der selben Position abgelegt, um diesen danach auch präzise an eine vorbestimmte Position transportieren zu können. Sowohl das Ablegen des Wafers auf der Transportvorrichtung wie auch die Transportvorrichtung selbst ist aber mit einer bestimmten Ungenauigkeit bzw. mit Toleranzfehlern behaftet. Weitere Ungenauigkeiten bzw. Verschiebungen der Waferposition auf der Transportvorrichtung können auch in der Prozessstation erfolgen durch Einwirkungen in der Prozesskammer. Aus diesem Grund muss die genaue Position des Wafers erfasst bzw. gemessen werden zur Kontrolle der korrekten Waferposition und / oder um entsprechende Korrekturen für die Positionierung vornehmen zu können. Üblicherweise werden dazu mehrere Sensoren verwendet. Diese Sensoren werden in bekannter Weise unmittelbar im Bereich der Endposition also in der Prozesskammer, wo der Prozess präzise statt finden soll, angeordnet und danach dort auf die Soll-Position endpositioniert. Die Verwendung von mehreren Sensoren und der hohe elektronische Aufwand zusammen mit dem Positionierungsvorgang mit der Transporteinrichtung führt zu sehr grossen Aufwendungen und ausserdem ist damit ,je höher der Aufwand der getrieben werden muss, auch die Systemzuverlässigkeit bzw. die Betriebssicherheit der Vakuumprozessanlage verringert. Dies kann zu Anlagenbetriebsausfällen führen, zu erhöhtem Unterhaltsaufwand und auch zu erhöhten Ausschüssen bei der Produktion von teuren Halbleiterwafern.

Es wurden deshalb immer wieder Lösungen gesucht, einfachere Transportsysteme mit vereinfachtem Positionierverfahren zu realisieren, um den Aufwand zu verringern und die Zuverlässigkeit zu erhöhen. Aus der US 6,760,976 B1 ist ein Verfahren zur Zentrierung eines Halbleiterwafers bekannt geworden, bei dem anstelle von mehreren Positioniersensoren ein einzelner Sensor eingesetzt wird. Das Verfahren geht davon aus, dass ein kreisrunder Wafer eingesetzt wird, bei dem der Durchmesser bekannt ist und durch Anfahren der Waferkante an den Sensor mindestens zwei Punkte erfasst werden und mit diesen Messergebnissen zusammen mit dem bekannten Waferdurchmesser das tatsächliche Lagezentrum des Wafers ermittelt werden kann. Auf Grund dieser ermittelten Zentrumslage des Wafers kann dann eine Korrektur erfolgen und der Wafer mit der Transporteinrichtung in die gewünschte Soll-Position für den nachfolgenden Prozessschritt gefahren werden. Dieses Verfahren lässt sich anwenden bei kreisrunden Wafersubstraten, bei welchen die Peripherie eine kreisrunde geschlossene Linie aufweist und nicht gestört ist. Halbleiterwafer, wie sie heute verwendet werden, benötigen an der Kreisperipherie eine sogenannte Bezugsmarke, beispielsweise einen sogenannten Flat welcher der zirkularen Positionserkennung für die Ausrichtung der Bauteile auf dem Wafer und des Wafer selbst dient. Sobald ein Wafer dieser Art bearbeitet werden muss, führt das vorerwähnte Verfahren zu Fehlern bzw. Versagen, wenn vom Sensor Kantenbereiche erfasst werden, die von der kreisrunden Form abweichen.

Dieses Verfahren ist deshalb für Wafer mit Bezugsmarken nicht einsetzbar.

Ein weiteres Zentrierungsverfahren für Wafer wird zum Beispiel in der US 5,264,918 A1 offenbart.

Die Aufgabe der vorliegenden Erfindung liegt darin, die vorerwähnten Nachteile des Standes der Technik zu beseitigen. Insbesondere besteht die Aufgabe darin, ein Verfahren zur Positionierung eines Wafers mit einer Bezugsmarke in einer Vakuumprozessanlage durchführen zu können, welches mit hoher Zuverlässigkeit und hoher Präzision arbeitet und eine wirtschaftliche Realisierung ermöglicht.

Die Aufgabe wird erfindungsgemäss durch ein Verfahren zur Positionierung eines kreisrunden Wafers, der eine Bezugsmarke an der Waferperipherie enthält, nach Anspruch 1 gelöst. Die abhängigen Ansprüche definieren weitere vorteilhafte Ausführungsformen.

Die Erfindung wird nun nachfolgend beispielsweise und mit schematischen Figuren näher erläutert. Es zeigen:
- Fig. 1a: ein Wafer, der auf der Halterung einer Transpor- teinrichtung abgelegt ist in schräger dreidimen- sionaler Ansicht mit Blick auf die Bezugsmarke des Wafers und in Richtung der einen Bewegungs- richtung
- Fig. 1b: die Anordnung entsprechend Fig. 1a in Aufsicht
- Fig. 2a: ein Wafer mit Bezugsmarke und Darstellung der zu- gehörigen in die eine, radiale Transportrichtung projektierten Waferzone und mit den resultieren- den freien Zonen
- Fig. 2b: ein Wafer entsprechend der Fig. 2a mit den Zonen, die sich ergeben bei Verwendung der Transportein- richtung für verschieden grosse Wafer, wie hier für zwei unterschiedliche Waferdurchmesser
- Fig. 3a: Messwerte von mehreren Wafer-Ist-Positionen und deren Abweichung von der Soll-Position bei Fal- scheinstellung des Transportsystems in Polardar- stellung
- Fig. 3b: Darstellung der Messwerte entsprechend Fig. 3a abhängig von der Zeit
- Fig. 4a: Messwerte von mehreren Wafern mit Darstellung der Abweichung von der Soll-Position bei Verschieben des Wafer auf der Transporteinrichtung durch Ver- kleben bzw. Haften an Abschirmeinrichtungen in Polardarstellung
- Fig. 4b: Darstellung der Messwerte entsprechend der Fig. 4a im zeitlichen Verlauf
- Fig. 5a: Messwerte von mehreren Wafern mit Darstellung der Verschiebung von der Soll-Position bei Verschie- befehlern durch eine elektrostatische Halterung, in Polardarstellung
- Fig. 5b: Darstellung der Messwerte entsprechend Fig. 5a im zeitlichen Verlauf

Kreisförmige bzw. scheibenförmige flache Substrate wie insbesondere Halbleiterwafer 3, beispielsweise Siliziumwafer, weisen üblicherweise eine sogenannte Bezugsmarke 6, oft auch Flat genannt, auf, mit welcher der scheibenförmige Wafer 3 für eine zirkulare Positionierung bzw. in seiner Drehlage bezogen auf das Zentrum der kreisrunden Waferperipherie, erfasst werden kann. Ein solcher Flat wird üblicherweise als kleiner segmentartiger Abschnitt an der Waferperipherie ausgebildet, so dass Der grösste Anteil der Waferkante als kreisrunde Peripherie verbleibt. Diese grösstenteils kreisrunde Scheibe kann somit an diesem Flat in seiner Drehlage erkannt bzw. ausgerichtet werden. Eine Bezugsmarke 6 kann beispielsweise auch als Einkerbung an der Waferkante ausgebildet sein.

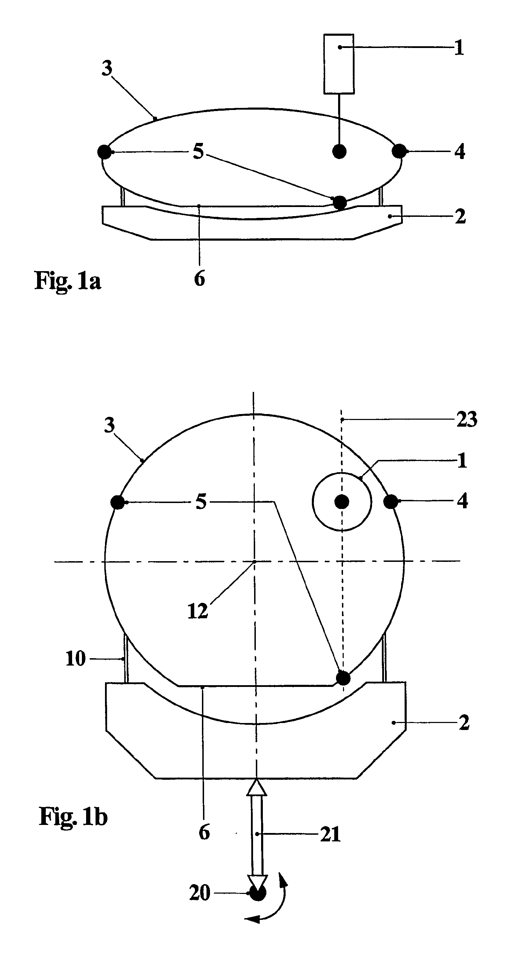

Solche Halbleiterwafer 3 sind in der Regel einige Zehntel mm dick und weisen Durchmesser auf im Bereich von einigen cm bis einige zehn cm, wie beispielsweise typischerweise üblich im Bereich von etwa 10 bis 30 cm Durchmesser. An die Bearbeitung solcher Wafer 3 in Vakuumprozessanlagen werden sehr hohe Anforderungen gestellt. Insbesondere müssen derartige Wafer 3 sehr präzise im Bereich der Prozessstationen für die Bearbeitung positioniert werden. Die Positionierung mit auftretenden Abweichungen von der Soll-Position müssen auch laufend erfasst werden, um Prozessfehler mit Ausschussfolgen vermeiden zu können. In Vakuumprozessanlagen zur Bearbeitung von Halbleiterwaferoberflächen werden in der Regel mehrere Prozessschritte nacheinander ausgeführt, wobei dieser Vorgang höchst automatisiert abläuft. Wegen der Empfindlichkeit derartiger Wafer 3 werden diese üblicherweise in einer horizontalen Ebene transportiert, wobei die Ebene der Waferscheibe in der Regel im Wesentlichen parallel zur Transportebene verläuft oder mit dieser zusammenfällt. Der Wafer 3 wird bei dieser Transportweise auf eine Transporteinrichtung 2, 20, 21 abgelegt und liegt somit nur mit seinem eigenen Gewicht auf einer Waferhalterung 10 auf. Hierdurch werden mit der Halterung nur Bereiche der Waferrückseite berührt und eine Berührung der empfindliche zu bearbeitenden Frontseite vermieden. Ein eigentliches Festhalten des Wafers, beispielsweise an seiner Peripherie, kann damit vermieden werden und die empfindliche Waferoberfläche kann dadurch vor allem auch im empfindlichen Kantenbereich geschont werden. In derartigen Vakuumprozessanlagen werden Wafer 3 über eine Schleusenkammer in den Vakuumbereich eingeschleust und dann von dieser Schleusenkammer in die entsprechenden Transportkammern mit Hilfe einer Transporteinrichtung 2, 20, 21 in die Prozesskammer transportiert, wo sie mit entsprechenden Vakuumprozessen bearbeitet werden, wie beispielsweise Beschichtungs- und / oder Ätzprozesse. Um einen weiteren Prozessschritt durchführen zu können, wie beispielsweise eine zweite Beschichtung, ohne den Wafer 3 aus der Anlage herausbringen zu müssen, wird der Wafer 3 mit der Transporteinrichtung in die nächste Prozesskammer geführt, dort abgelegt und dann bearbeitet. Je nach Anforderung und Ausbildung der Vakuumprozessanlage können auf diese Art und Weise mehrere Prozessschritte automatisch nacheinander durchgeführt werden. Besonders bevorzugte Vakuumprozessanlagen sind sogenannte Clustersysteme. Derartige Anlagen weisen eine im wesentlichen zentral liegende Transportvakuumkammer auf, in welcher eine Transporteinrichtung 2, 20, 21 angeordnet ist für die Aufnahme und Bewegung eines Wafers 3 in einer Transportebene, wobei an dieser mindestens zwei Prozesskammern oder mehrere Kammern angeordnet sind und die Wafer nacheinander in diese Prozesskammer hineintransportiert werden zur Bearbeitung. An der im Wesentlichen zentral angeordneten Transportkammer ist mindestens eine weitere Kammer angeordnet, welche eine Vakuumschleuse bildet. Die Schleusenkammer und die Prozesskammer wird mit Elementen zur Abschottung der verschiedenen Vakuumatmosphären wie beispielsweise mit Schleusen versehen, welche es ermöglichen den Wafer 3 mit Hilfe der Transporteinrichtung in die entsprechenden Kammern einzubringen. Hierbei greift die Transporteinrichtung durch diesen Bereich hindurch. Und entfernt sich wieder aus diesem Bereich, wenn der Wafer abgelegt worden ist zum Bearbeiten und / oder Einschleusen in das System. Bei derartigen Anlagen wird eine Transporteinrichtung in der zentral liegenden Transportkammer der Vakuumprozessanlage derart angeordnet, dass sie auf die verschiedenen peripher angeordneten Kammern zugreifen kann. Die Transporteinrichtung 2, 20, 21 wird hierbei bevorzugt als Transportarm 21 ausgebildet, welcher um ein Rotationszentrum 20 mit vertikaler Achse in der Transportkammer angeordnet rotieren kann und hierbei in radialer Richtung von diesem Zentrum 20 hin oder weg bewegt werden kann wie dies in Fig. 1b mit den Richtungspfeilen beim Transportarm 21 dargestellt ist. Die Transporteinrichtung 2 mit daran angeordnetem Transportarm 21, welcher die radiale Auslenkung ermöglicht, kann auf verschiedene Art und Weise wie beispielsweise als scherenartiges Auslegersystem oder als balgförmiges, linear radial bewegliches System ausgebildet sein. Für die Rotationsbewegung um das Rotationszentrum 20 und die radiale Bewegung der Transporteinrichtung 2, 20, 21 werden in bekannter Weise gesteuerte Antriebe verwendet wie beispielsweise elektronisch gesteuerte Elektromotorantriebe, welche eine präzise Steuerung und Positionierung ermöglichen.

Zum Transportieren wird der Wafer 3 am Endbereich der armförmigen Transporteinrichtung, an der vom Rotationszentrum 20 abgewandten Armseite, auf einer daran angeordneten Waferhalterung 10 in vorgegebener definierter Position gegenüber der Halterung 10 abgelegt. Die abzulegenden Wafer 3 müssen immer in derselben Position auf der Waferhalterung 10 abgelegt werden. Die Wafer werden diesbezüglich entsprechend ihrer Bezugsmarke 6 auf der Halterung 10 ausgerichtet und immer wieder gleich abgelegt. Somit ist auch die Lage des Waferzentrums 12 definiert, da der Wafer 3 kreisrund ist und dieser einen vorbekannten Waferdurchmesser aufweist. Neben dem Waferzentrum 12, welches die Soll-Position des Wafer 3 darstellt, ist auch die Waferkante bzw. die Waferperipherie festgelegt. Beim Ablegen des Wafer 3 auf die Halterung 10 können bereits gewisse Ungenauigkeiten auftreten. Zusätzlich ist auch die Transporteinrichtung 2, 20, 21 mit gewissen Toleranzen behaftet. Weitere Probleme entstehen, wenn der Wafer beispielsweise in der Prozesskammer durch bestimmte Einflüsse beim Ablegen und wieder Aufnehmen gegenüber der ursprünglichen Soll-Position 12 leicht verschoben wird. Um derartige Fehler bzw. Abweichungen von der Soll-Position des Waferzentrum 12 feststellen zu können und entsprechende Korrekturmassnahmen vornehmen zu können, muss die tatsächliche Ist-Position des Wafers erfasst und kontrolliert bzw. mit der Soll-Position verglichen werden. Hierzu dient ein einzelner Sensor 1, der Positionspunkte an der Waferkante detektiert, wie dies in Fig. 1 schematisch dargestellt ist. Hierzu kann beispielsweise ein optischer Sensor 1 verwendet werden, der unterhalb oder vorzugsweise oberhalb des Wafers angeordnet ist und berührungslos beim Verschwenken des Wafers in der Transportebene das erscheinen der Kante des Wafers 3 erfasst. Für die Erfassung der Ist-Position des Waferzentrum 12 werden zwei Detektionspunkte 4, 5 an der Waferkante erfasst. Durch Bewegen des Wafers 3 unter dem Sensor 1 in die eine Bewegungsrichtung, beispielsweise Rotieren um das Rotationszentrum 20, wird ein erster Detektionspunkt 4 bzw. 5 ermittelt und durch Bewegen des Wafer 3 in radialer Richtung hin oder weg vom Rotationszentrum 20 entlang der Detektionslinie 23 wird ein zweiter Detektionspunkt 5 ermittelt. Da der Wafer 3 kreisrund ist und der Durchmesser des Wafer 3 bekannt ist, kann somit mit Verwendung der Positionserfassung der Transporteinrichtung 2, 20, 21 in Kombination mit dem Detektionssignal des Sensor 1 die wahre Position des Wafers 3 bzw. des Waferzentrums 12 ermittelt werden. Erfindungsgemäss muss hierbei darauf geachtet werden, dass die zu detektierende Waferkante ausschliesslich auf den kreisrunden Bereich des Wafer 3 begrenzt wird. Der Kantenbereich der Bezugsmarke 6 muss für diesen Messvorgang vermieden werden. Ausserdem muss dafür gesorgt werden, dass die Waferhalterung 10 nicht den zu messenden Bereich stört, wenn der Sensor auf der Seite der Halterung angeordnet ist. Die Bezugsmarke 6 eines Wafer 3 ist üblicherweise als segmentartiger Abschnitt der Waferscheibe ausgebildet, kann beispielsweise aber auch kerbförmig ausgebildet sein.

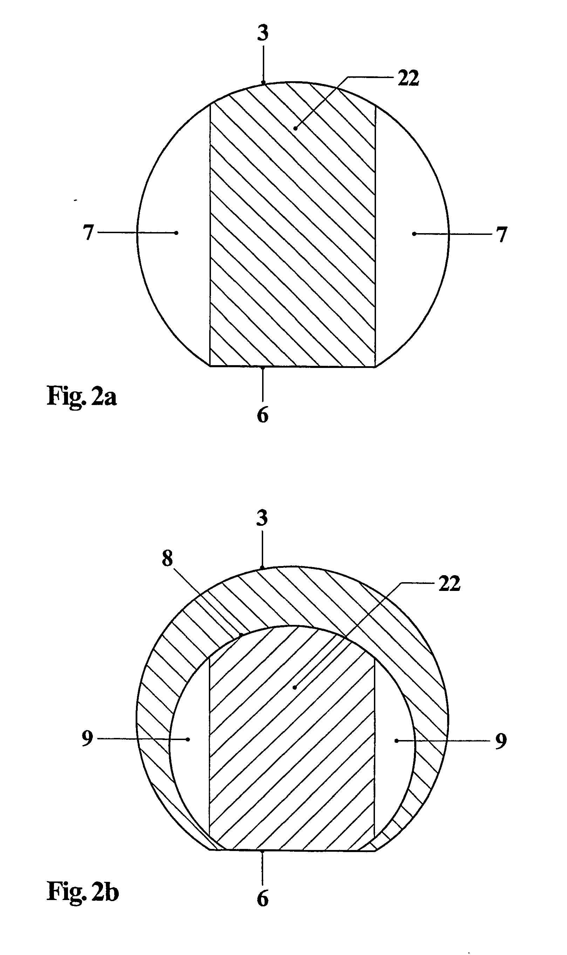

Die Bezugsmarke 6 wird bevorzugt symmetrisch zur Achse der einen Bewegungsrichtung angeordnet, wodurch die Breite der Bezugsmarke in Bewegungsrichtung projiziert auf der Oberfläche des Wafer 3 eine unerlaubte Zone 22, wie in Fig. 2a schraffiert dargestellt, definiert. An sich könnte die Bezugsmarke 6 auch asymmetrisch zu dieser einen Bewegungsrichtung angeordnet werden auf der Halterung 10 der Transporteinrichtung, dies würde dann aber zu komplizierteren Bereichen führen, welche die unerlaubte Zone 22 bilden, weil in diesem Fall die Projektionen von zwei überlagerten Bewegungsrichtungen berücksichtigt werden müssten. Bei der bevorzugten Transporteinrichtung mit Rotationszentrum 20 und mit um diesem drehenden radial beweglichem Transportarm 2, 21 wird der Wafer 3 mit seiner Bezugsmarke 6 bevorzugt, derart auf der Halterung abgelegt, dass die Bezugsmarke 6 gegen das Rotationszentrum 20 gerichtet ist und im weiteren bevorzugt symmetrisch zur Achse der radialen Transportrichtung des Transportarm 21 abgelegt ist, wie dies in Fig. 1b schematisch dargestellt ist.

Entsprechend dem in Fig. 1b dargestelltem Beispiel ergeben sich dann, wie in Fig. 2a dargestellt ist Zonen 7, 22 auf der Waferoberfläche, die bestimmt werden durch die Bezugsmarke 6 des Wafer 3 und die eine radiale Bewegungsrichtung durch die Projektion der Bezugsmarke 6 welche eine unerlaubte schraffierte Zone 22 darstellt, die von der Bezugsmarke 6 bis auf die gegenüberliegende periphere Kante des Wafers 3 reicht. Die daraus sich ergebenden seitlich zur unerlaubten Zone 22 beiden segmentartigen freien Zonen 7 weisen somit ausschliesslich Kantenbereiche auf, die auf einer Kreislinie liegen. Erfindungsgemäss wird die Transporteinrichtung 2, 20, 21 mit dem darauf abgelegten Wafer 3 derart gegenüber dem an vorbestimmter Position angeordnetem Sensor 1 positioniert und geführt, dass beim Erfassen der Waferkante ausschliesslich die beiden Detektionspunkte 4, 5 an der Waferperipherie der sogenannten freien Zonen 7 detektiert und für die Positionserfassung ausgewertet werden. Die Toleranzbänder der Ungenauigkeit der Transporteinrichtung selbst und der Ungenauigkeit der Waferablage auf der Halterung 10 werden mit Vorteil zusätzlich berücksichtigt bei der Festlegung der Grösse der Fläche dieser freien Zonen 7, beispielsweise durch überlagern der zugehörigen Flächen, was in den Figuren nicht dargestellt ist. Der Sensor 1 für die Erfassung der beiden Detektionspunkte 4, 5 an der Waferkante wird mit Vorteil in der Transportkammer im Einschleusbereich vor der Prozesskammer angeordnet. Es ist von Vorteil, den Wafer, nach dem er in er Prozesskammer bearbeitet worden ist, aus dieser herauszutransportieren in die Zwischenkammer, dann zu vermessen und aus den Messergebnissen die Trendanalyse zu erstellen und dann entsprechend den Ergebnissen, wenn ein bestimmter Abweichungsgrad ermittelt worden ist, entsprechende Korrekturmassnahmen zu ergreifen, wie vorzugsweise die Nachführung der Positionierung zur Präzisierung der Positionierung und / oder beispielsweise aber auch andere geeignete Massnahmen am System bei den nächsten Transport- und / oder Prozessschritten.

Die Vakuumprozessanlage mit der Transporteinrichtung kann auch universell ausgelegt werden zur Verarbeitung von Wafern 3 mit verschieden grossen Durchmessern. Um die freien erlaubten Zonen 7 für die erfinderische Positionierungseinrichtung festlegen zu können, wird in diesem Fall der grösste zu bearbeitende Wafer 3 und der kleinste zu bearbeitende Wafer 8 in Projektion übereinander gelegt betrachtet und an den beiden Bezugsmarken 6 ausgerichtet, wie dies in Fig. 2b dargestellt ist. Die sich ergebende freie Zone für die Anordnung der zulässigen Messpositionen ergibt sich dann aus den gebildeten freien Zonen 9 der sogenannten Überlappungszone, die durch den kleinsten zu bearbeitenden Wafer 8 bestimmt wird. Die Waferhalterung 10 sollte auch hier, wie bereits erwähnt, unterhalb der verbotenen Zone 22 angeordnet sein. Um eine hohe Messgenauigkeit zu erreichen, ist es sinnvoll, die Messpunkte weit auseinander liegend zu wählen, wobei aber dieser Abstand nicht grösser als der Waferdurchmesser sein kann.

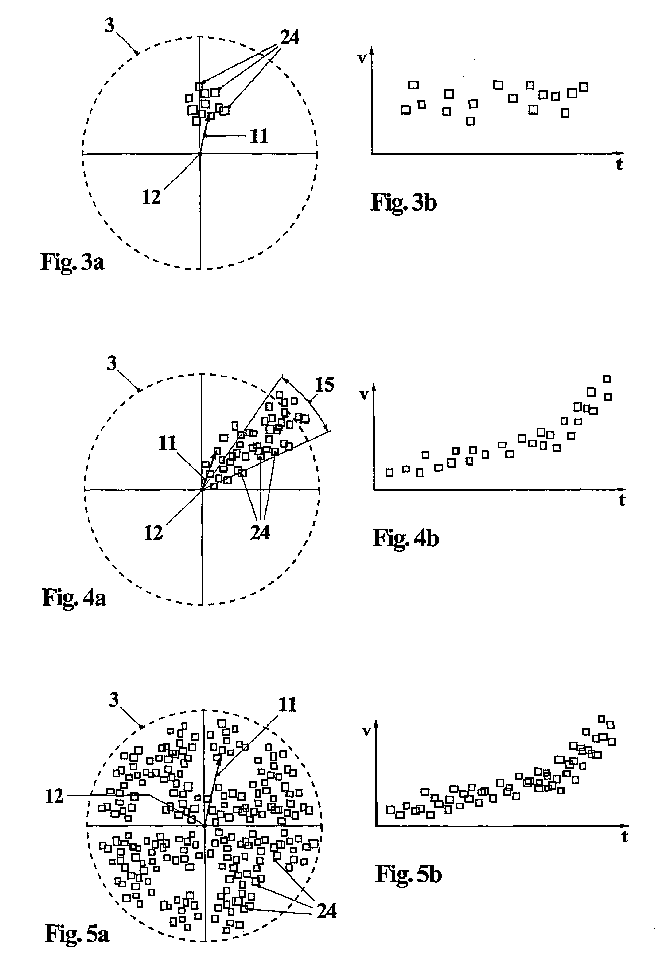

Die präzise Auswertungsmöglichkeit durch das vorliegende Positionierungsverfahren erlaubt nun zusätzlich verschiedene Betriebszustände in der Vakuumprozessanlage und insbesondere in der Prozesskammer zu ermitteln. Mit Hilfe von entsprechenden Analysen der Ergebnisse können einerseits ganz bestimmte Vorgänge zugeordnet und festgestellt werden und es können zusätzlich Trendanalysen durchgeführt werden. Der sichere Betrieb einer derartigen Prozessanlage kann dadurch ganz wesentlich gesteigert werden. Beispielsweise können rechtzeitig Korrekturmassnahmen ergriffen werden, wodurch die Qualität der Produktion erhalten bleibt bei längerer Produktionszeit und andererseits kann rechtzeitig erkannt werden, wenn präventiv Unterhaltsarbeiten notwendig werden, bevor Ausschuss produziert wird oder gar Schäden an der Prozessanlage entstehen. Werden beispielsweise mehrere Waferpositionen nacheinander ausgewertet und es wird festgestellt, dass die Soll-Position 12 des Wafer 3 regelmässig um einen ähnlichen Betrag des Verschiebevektors 11 verschoben wird und der Betrag des Vektors in etwa in der selben Grössenordnung liegt, wie dies in Fig. 3a in Polardarstellung dargestellt ist, dann kann daraus gefolgert werden, dass der Wafer 3 an einem bestimmten Anlagenteil, beispielsweise in der Prozessstation, berührt bzw. touchiert und dadurch eine Verschiebung der Waferposition auftritt. In diesem Fall ist die Verschiebelänge bzw. der Verschiebeweg des Verschiebevektors in etwa gleich gross über die Anzahl der Messwerte bzw. über die Zeit, wie dies in Fig. 3b schematisch aufgezeigt ist.

In Fig. 4a ist ein weiteres Beispiel dargestellt, bei welchem in Polardarstellung mehrere Messwerte einer Verschiebung der Soll-Position des Waferzentrum 12 dargestellt sind, wobei die Verschieberichtung in etwa die selbe ist und sich innerhalb einer bestimmten Bandbreite des Vektorwinkels 15 aufhält, wobei die Verschiebungsweglänge unterschiedlich ist. In Fig. 4b ist dargestellt, dass sich diese Verschiebungslänge über den Verlauf der Zeit und die Anzahl der Messwerte 24 vergrössert. Dieses Verhalten ist beispielsweise typisch für das Haften bzw. partielle Verkleben des Wafer 3 an einer Abschirmung, wie sie in Beschichtungsprozessstationen benötigt wird. Das bei der Beschichtung immer stärker aufwachsende Material an Abschirmungen oder Blenden führt dazu, dass ein Wafer beispielsweise durch eine Art anlöten daran haften kann und sich dieser mit dem immer stärkeren Aufwachsen der Schicht weiter weg verschiebt. Die Auswertung der Messresultate ermöglicht beispielsweise das erkennen des Zeitpunktes wann Anlagenbetrieb unterbrochen werden muss, um die Abschirmung zu reinigen oder zu ersetzen. Das rechtzeitige erkennen dieses Betriebszustandes ermöglicht beispielsweise die Vermeidung von Produktionsausschuss.

In der Polardarstellung der Fig. 5a sind Messwerte 24 gezeigt, die sich statistisch in alle Richtungen verteilen mit unterschiedlichen Verschiebelängen 11 des Wafers 3. Die Verschiebelängen 11 über die Zeit dargestellt in Fig. 5b zeigen auf, dass die Verschiebelänge mit der Zeit zunimmt. Dies ist ein typisches Problem welches bei sogenannten elektrostatischen Waferhalterungen auftritt. Das Problem verstärkt sich im Laufe der Betriebszeit und die Performance der Haltewirkung sinkt. Auch aus diesem Beispiel können entsprechende Massnahmen rechtzeitig abgeleitet werden bei Überschreiten eines vorgegebenen Masses. Wie die dargestellten Beispiele zeigen, kann durch einfaches Messen des Verschiebevektors 11, also sowohl durch Messen der Vektorrichtung wie auch dessen Länge, mit mehreren Messungen über die Zeit, die Ursache ermittelt werden welche die fehlerhaften Vorgänge auslösen. Es können somit gezielt und präzise die entsprechend notwendigen Korrekturmassnahmen abgeleitet und ergriffen werden.

## Patentansprüche

1. Verfahren zur Positionierung eines Wafers (3) mit einer Bezugsmarke (6) in einer Vakuumprozessanlage mit einer Transportkammer enthaltend eine Transporteinrichtung (2,20,21) zur Bewegung des Wafers (3) in einer Ebene zu einer an dieser Kammer angeordneten Prozesskammer und mit einem einzelnen Sensor (1) welcher vor der Prozesskammer innerhalb der Transportkammer angeordnet ist zur Erfassung der Position des Wafers (3) durch erfassen an dessen Kante an einem ersten Detektionspunkt (4) und an einem zweiten Detektionspunkt (5), derart dass mit elektronischer Auswertung der beiden gemessenen Detektionspunkte (4,5) die wahre Lage des Wafers (12) bei bekanntem Waferdurchmesser ermittelt wird und die Transporteinrichtung (2,20,21) den Wafer (3)auf eine gewünschte Sollposition nachführt, **dadurch gekennzeichnet dass** der Wafer (3) in Bezug auf seine Bezugsmarke (6) auf der Transporteinrichtung (2,20,21) in vorgegebener Position ausgerichtet abgelegt ist und die Projektion der Bezugsmarke (6) entlang einer Bewegungsrichtung auf dem Wafer (3) eine unerlaubte Zone (22) bestimmt und **dadurch** der übrige Bereich des Wafers (3) eine freie Zone definiert, wobei der Sensor (1) derart in der Transportkammer angeordnet ist, dass die unerlaubte Zone (22) sicher nicht überstrichen wird und der Sensor (1) **dadurch** nur den Kreisrunden Bereich der Waferkante erfassen kann und nicht Teile der Bezugsmarke (6).

2. Verfahren nach Anspruch 1, **dadurch gekennzeichnet dass** die Positionierung ein Zentrierungsvorgang des Wafers (3) ist zur Nachführung des Waferzentrums (12) auf die vorgegebene gewünschte Sollposition.

3. Verfahren nach einem der Ansprüche 1 oder 2, **dadurch gekennzeichnet dass** zuerst an einem ersten Wafer (3) gemessen wird und an weiteren nachfolgenden Transportschritten mit weiteren Wafer auf eine Sollposition korrigiert wird.

4. Verfahren nach einem der vorhergehenden Ansprüche, **dadurch gekennzeichnet dass** translatorische Versetzungsfehler korrigiert werden.

5. Verfahren nach einem der vorhergehenden Ansprüche, **dadurch gekennzeichnet dass** die Transporteinrichtung eine Rotationsbewegung und ein Rotationszentrum (20) und eine radiale Bewegung von diesem Zentrum weg und hin ausführt zum Transport und / oder Positionierung eines Wafers (3) in eine Prozesskammer und / oder einer Schleusenkammer.

6. Verfahren nach Anspruch 5, **dadurch gekennzeichnet dass** die Vakuumprozessanlage eine Cluster - Konfiguration ist.

7. Verfahren nach einem der vorhergehenden Ansprüche, **dadurch gekennzeichnet dass** nur zwei Detektionspunkte (4,5) an der Waferkante erfasst werden pro auszumessenden Wafer (3).

8. Verfahren nach einem der vorhergehenden Ansprüche, **dadurch gekennzeichnet dass** der Wafer (3) durch eine Rotationsbewegung und / oder lineare Bewegung in der Transportebene mit seiner Kante an den Sensor (1) geführt wird zur Erfassung der Detektionspunkte (4,5)

9. Verfahren nach einem der vorhergehenden Ansprüche, **dadurch gekennzeichnet dass** die Lage der Detektionspunkte (4,5) weit auseinander liegend gewählt werden aber weniger weit als der zu messende Waferdurchmesser.

10. herfahren nach einem der vorhergehenden Ansprüche, **dadurch gekennzeichnet dass** die Waferhalterung derart ausgebildet ist, dass diese den Messvorgang nicht stört und vorzugsweise unter die unerlaubte Zone (22) positioniert wird.

11. Verfahren nach einem der vorhergehenden Ansprüche, **dadurch gekennzeichnet dass** jeder Wafer (3) mit der Bezugsmarke (6) gleich ausgerichtet auf die Halterung der Transporteinrichtung (2,20,21) abgelegt wird vorzugsweise mit der Ausrichtung in Richtung der radialen lateralen Bewegung (21) gegen das Rotationszentrum (20) ausgerichtet

12. Verfahren nach einem der vorhergehenden Ansprüche, **dadurch gekennzeichnet dass** die Toleranzbänder der Positionierungsgenauigkeit der Transporteinrichtung (2,20,21) für die Festlegung der unerlaubten Zone (22) mit berechnet werden.

13. herfahren nach einem der vorhergehenden Ansprüche, **dadurch gekennzeichnet dass** verschiedene Wafergrössen berücksichtigt werden und diese ausgehend von der gleichen Lage deren Bezugsmarken (6) ausgehend eine Überlappungszone (9) bildet welche die freie Zone (7) darstellt.

14. herfahren nach einem der vorhergehenden Ansprüche, **dadurch gekennzeichnet dass** die gemessenen Abweichungen von der Sollposition der Wafer (3), vorzugsweise für jeden Wafer (3) erfasst und gespeichert wird zur Erfassung des Systemzustandes für die Ableitung von Korrekturmassnahmen.

15. Verfahren nach einem der vorhergehenden Ansprüche, **dadurch gekennzeichnet dass** der Wafer (3) in der Prozesskammer zuerst bearbeitet wird und danach aus der Prozesskammer in die Transportkammer transportiert wird und dort mit dem einzelnen Sensor (1) vermessen wird und die Messwerte mit elektronischen Mitteln verarbeitet werden und bei erreichen und /oder überschreiten eines vorgegebenen Wertes entsprechende Korrekturmassnahmen beim einem der nachfolgenden Prozesschritte vorgenommen werden.

16. Verfahren nach Anspruch 15, **dadurch gekennzeichnet dass** mehrere Messschritte verarbeitet werden und ein Trend zur Fehlerart ermittelt wird und danach Massnahmen bestimmt werden für die weitere Betriebsweise der Vakuumprozessanlage, insbesondere zur Ansteuerung der Transporteinrichtung (2, 20, 21).

17. Verfahren nach Anspruch 16, **dadurch gekennzeichnet dass** die Trendanalyse das Berühren des Wafers (3) wegen Falscheinstellung der Transporteinrichtung mit dem Wafer (3) erfasst.

18. Verfahren nach Anspruch 16, **dadurch gekennzeichnet dass** die Trendanalyse das örtliche Verschieben des Wafers (3) auf der Halterung (10) der Transporteinrichtung auf Grund von Schichtaufwachsungen an Blendenteilen während dem Prozess erfasst.

19. Verfahren nach Anspruch 16, **dadurch gekennzeichnet dass** die Trendanalyse den Wirkungsgradverlust der Haltekraft einer elektrostatischen Waferhalterung über die Betriebszeit erfasst.

## Claims

1. Method for positioning a wafer (3) with a reference mark (6) in a vacuum process plant with a transport chamber comprising a transport device (2, 20, 21) for movement of the wafer (3) in a plane to a process chamber arranged on this chamber and with a single sensor (1) which is arranged before the process chamber inside the transport chamber to detect the position of the wafer (3) by detecting at its edge a first detection point (4) and a second detection point (5) such that by electronic analysis of the two detection points (4, 5) measured, the true position of the wafer (12) is determined with a known wafer diameter, and the transport device (2, 20, 21) guides the wafer (3) to a desired nominal position, **characterised in that** the wafer (3) is laid on the transport device (2, 20, 21) in a specified position in relation to its reference mark (6) and the projection of the reference mark (6) along a movement direction on the wafer (3) determines a forbidden zone (22) and thus the remaining area of the wafer (3) defines a free zone, wherein the sensor (1) is arranged in the transport chamber such that the forbidden zone (22) is certainly not covered and the sensor (1) as a result can detect only the circular area of the wafer edge and not parts of the reference mark (6).

2. Method according to claim 1, **characterised in that** the positioning is a centring process of the wafer (3) to guide the wafer centre (12) to the pre-specified desired nominal position.

3. Method according to any of claims 1 or 2, **characterised in that** the measurement is performed first on a first wafer (3) and corrected to a nominal position in further subsequent transport stages with further wafers.

4. Method according to any of the preceding claims, **characterised in that** translational movement errors are corrected.

5. Method according to any of the preceding claims, **characterised in that** the transport device executes a rotational movement about a rotation centre (20) and a radial movement away from and to this centre for transport and/or positioning of a wafer (3) in a process chamber and/or a lock chamber.

6. Method according to claim 5, **characterised in that** the vacuum processing plant is a cluster configuration.

7. Method according to any of the preceding claims, **characterised in that** only two detection points (4, 5) on the wafer edge are detected per wafer (3) to be measured.

8. Method according to any of the preceding claims, **characterised in that** the wafer (3) is guided by a rotation movement and/or linear movement in the transport plane with its edge at the sensor (1) to detect the detection points (4, 5).

9. Method according to any of the preceding claims, **characterised in that** the positions of the detection points (4, 5) are selected lying far apart but less far apart than the wafer diameter to be measured.

10. Method according to any of the preceding claims, **characterised in that** the wafer holder is designed such that this does not disrupt the measurement process and is preferably positioned below the forbidden zone (22).

11. Method according to any of the preceding claims, **characterised in that** each wafer (3) is deposited on the holder of the transport device (2, 20, 21) with the reference mark (6) aligned in the same way, preferably with the alignment in the direction of the radial lateral movement (21) in relation to the rotation centre (20).

12. Method according to any of the preceding claims, **characterised in that** the tolerance bands of the positioning accuracy of the transport device (2, 20, 21) are taken into account to establish the forbidden zone (22).

13. Method according to any of the preceding claims, **characterised in that** different wafer sizes are taken into account, and starting from the same position of their reference marks (6), these form an overlap zone which constitutes the free zone (7).

14. Method according to any of the preceding claims, **characterised in that** the deviations measured from the nominal position of the wafers (3) are preferably detected and stored for each wafer (3) to detect the system state for the derivation of correction measures.

15. Method according to any of the preceding claims, **characterised in that** the wafer (3) is first processed in the process chamber and then transported out of the process chamber to the transport chamber and there measured with the single sensor (1), and the measurement values are processed by electronic means and when a pre-specified value is reached and/or exceeded, corresponding correction measures are taken at one of the subsequent process steps.

16. Method according to claim 15, **characterised in that** several measurement steps are processed and a trend towards a fault type determined and from this measures are determined for the further operation of the vacuum process plant, in particular to control the transport device (2, 20, 21).

17. Method according to claim 16, **characterised in that** the trend analysis detects the contact of the wafer (3) due to incorrect setting of the transport device with the wafer (3).

18. Method according to claim 16, **characterised in that** the trend analysis detects the local displacement of the wafer (3) on the holder (10) of the transport device due to epitaxial layer growth on mask parts during the process.

19. Method according to claim 16, **characterised in that** the trend analysis detects the efficiency loss of the retention force of an electrostatic wafer holder over the operating time.

## Revendications

1. Procédé de positionnement d'une plaquette (3) avec un repère de référence (6) dans une installation de traitement sous vide qui inclut une chambre de transport, contenant une dispositif de transport (2, 20, 21) pour déplacer la plaquette (3) dans un plan vers une chambre de traitement adjacente à cette chambre, ainsi qu'un capteur unique (1) qui est disposé à l'intérieur de la chambre de transport avant la chambre de traitement pour détecter la position de la plaquette (3) en détectant sur son arête un premier point de détection (4) et un deuxième point de détection (5), d'une manière telle que la vraie situation de la plaquette (3) est établie pour un diamètre connu de plaquette par évaluation électronique des deux points de détection mesurés (4, 5) et que le dispositif de transport (2, 20, 21) oriente la plaquette (3) selon une position de consigne souhaitée, **caractérisé en ce que** la plaquette (3) est déposée sur le dispositif de transport (2, 20, 21) en étant ajustée dans une position prédéfinie en référence à son repère de référence (6) et que la projection du repère de référence (6) selon une direction de déplacement détermine une zone interdite (22) sur la plaquette (3), et que la région restante de la plaquette (3) définit de cette manière une zone libre, le capteur (1) étant disposé dans la chambre de transport d'une manière telle que la zone interdite (22) n'est certainement pas balayée et que le capteur (1) ne peut donc détecter que la région circulaire de l'arête de plaquette et non des parties du repère de référence (6).

2. Procédé selon la revendication 1, **caractérisé en ce que** le positionnement est une manoeuvre de centrage de la plaquette pour ajuster le centre (12) de la plaquette sur la position de consigne souhaitée prédéfinie.

3. Procédé selon la revendication 1 ou 2, **caractérisé en ce que** des mesures sont d'abord effectuées sur une première plaquette (3), et que des corrections sont apportées à une position de consigne pour d'autres plaquettes lors d'autres étapes de transport suivantes.

4. Procédé selon l'une quelconque des revendications précédentes, **caractérisé en ce que** des erreurs de déport en translation sont corrigées.

5. Procédé selon l'une quelconque des revendications précédentes, **caractérisé en ce que** le dispositif de transport exécute un déplacement de rotation autour d'un centre de rotation (20) et un déplacement radial vers ce centre ou en direction opposée afin de transporter une plaquette (3) vers une chambre de traitement et / ou une chambre de sas et / ou de l'y positionner.

6. Procédé selon la revendication 5, **caractérisé en ce que** la configuration de l'installation de traitement sous vide est en grappe.

7. Procédé selon l'une quelconque des revendications précédentes, **caractérisé en ce que** seuls deux points de détection (4, 5) sont détectés sur l'arête de la plaquette pour chaque plaquette (3) à mesurer.

8. Procédé selon l'une quelconque des revendications précédentes, **caractérisé en ce que** la plaquette (3) est guidée avec son arête vers le capteur (1) pour la détection des points de détection (4, 5), au moyen d'un déplacement de rotation et / ou d'un déplacement linéaire dans le plan de transport.

9. Procédé selon l'une quelconque des revendications précédentes, **caractérisé en ce que** les situations des points de détection (4, 5) sont choisies à distance l'une de l'autre, mais à une distance inférieure au diamètre de la plaquette à mesurer.

10. Procédé selon l'une quelconque des revendications précédentes, **caractérisé en ce que** la bride de support de plaquette est formée d'une manière telle qu'elle ne gêne pas le déroulement des mesures et est positionnée de préférence au dessous de la zone interdite (22).

11. Procédé selon l'une quelconque des revendications précédentes, **caractérisé en ce que** chaque plaquette (3) est déposée sur la bride de support du dispositif de transport (2, 20, 21) d'une manière telle que le repère de référence (6) est toujours ajusté de la même manière, qui est de préférence telle que le repère de référence (6) est ajusté pour faire face au centre de rotation (20), en vue selon la direction du déplacement linéaire radial (21).

12. Procédé selon l'une quelconque des revendications précédentes, **caractérisé en ce que** les bandes de tolérance de la précision de positionnement du dispositif de transport (2, 20, 21) sont intégrées dans le calcul de la spécification de la zone interdite (22).

13. Procédé selon l'une quelconque des revendications précédentes, **caractérisé en ce qu'**il prend en compte diverses dimensions de plaquettes qui établissent, en partant de la même situation de leurs repères de référence (6), une zone de recouvrement (9) qui représente la zone libre (7).

14. Procédé selon l'une quelconque des revendications précédentes, **caractérisé en ce que** les écarts mesurés par rapport à la position de consigne de la plaquette (3) sont détectés et mémorisés de préférence pour chaque plaquette (3) afin de détecter l'état du système pour déduire des dispositions de correction.

15. Procédé selon l'une quelconque des revendications précédentes, **caractérisé en ce que** la plaquette (3) est d'abord élaborée dans la chambre de traitement et est ensuite transportée hors de la chambre de traitement jusque dans la chambre de transport et y est ensuite mesurée par le capteur unique (1), et les valeurs de mesures sont converties par des moyens électroniques et des dispositions de correction correspondantes sont prises au cours de l'une des étapes suivantes du processus lorsqu'une valeur prédéfinie a été atteinte et / ou dépassée.

16. Procédé selon la revendication 15, **caractérisé en ce que** plusieurs étapes de mesures sont converties et une tendance vers un type d'erreurs est établie, et des dispositions sont ensuite définies pour le mode opératoire ultérieur de l'installation de traitement sous vide, en particulier pour la commande du dispositif de transport (2, 20, 21).

17. Procédé selon la revendication 16, **caractérisé en ce que** l'analyse de tendance détecte, au moyen de la plaquette (3), un contact de plaquette (3) dû à un réglage erroné du dispositif de transport.

18. Procédé selon la revendication 16, **caractérisé en ce que** l'analyse de tendance détecte le glissement local de la plaquette (3) sur la bride de support (10) du dispositif de transport, résultant de croissances de couches sur des parties masquées.

19. Procédé selon la revendication 16, **caractérisé en ce que** l'analyse de tendance détecte la perte d'efficacité de la force de maintien d'une bride de support électrostatique au cours du temps de fonctionnement.
